# EUROPEAN PATENT SPECIFICATION

(11) **EP 0 640 849 B1**
(45) Date of publication and mention of the grant of the patent: **16.12.1998**
(21) Application number: 94306276.0
(22) Date of filing: 25.08.1994
(51) Int. Cl.: G02B 1/10, C03C 17/34

(54) **An optical film, an antireflection film, a reflection film, a method for forming the optical film, the antireflection film or the reflection film and an optical device**
Optische Schicht, Antireflektionsschicht, Reflexionsfilm, Herstellungsverfahren für die optische Schicht, die Antireflektionsschicht oder den Reflexionsfilm und eine optische Vorrichtung dafür
Film optique, couche antiréfléchissante, couche réflective, méthode de fabrication du film optique, de la couche antiréfléchissante ou la couche réflective et un dispositif optique

(30) Priority: 25.08.1993 JP 210047/93; 20.12.1993 JP 320458/93
(43) Date of publication of application: 01.03.1995
(73) Proprietor: FUJITSU LIMITED, Kawasaki-shi, Kanagawa 211 (JP)
(72) Inventor: Okada, Nobumasa, c/o Fujitsu Limited, Kawasaki-shi, Kanagawa 211 (JP); Ohsaka, Shigeo, c/o Fujitsu Limited, Kawasaki-shi, Kanagawa 211 (JP); Miura, Shuichi, c/o Fujitsu Limited, Kawasaki-shi, Kanagawa 211 (JP)
(74) Representative: Silverman, Warren

(56) References cited:
- EP-A- 0 526 966
- EP-A- 0 536 607
- PATENT ABSTRACTS OF JAPAN vol. 14, no. 145 (E-0905) 19 March 1990 & JP-A-02 007 589 (SHARP CORP.) 11 January 1990

## Description

The invention relates to an antireflection or reflection optical film and a method for forming the same, and to an optical device having such an optical film.

In recent years, optical telecommunication systems using optical fibres have been made longer in distance, greater in capacity, and faster in speed, and light has been used for signal transmission between integrated circuits. Thus, information transmission technologies using lightwaves have developed remarkably.

In order to make further progress in these technologies, it is necessary to develop a precisely made high-output and stable light source, a means for precisely controlling light, a transmission path which loses less light, an optical transducer which loses less light, and so on. A means for precisely controlling light includes the use of various optical films in an optical transmission path, an optical transducer, and the like, and the use of antireflection film, a reflection film, and the like for composing the resonator of a semiconductor laser (a laser diode).

An antireflection film formed on the optical output end face of a semiconductor laser must have a reflectivity of 0.01% or less. In the ordinary technical field of lens coating, a multi-layered dielectric film comprising 15 layers is used to attain this reflectivity.

Such a multi-layered dielectric film cannot be used in a semiconductor laser as it is, because the material of which the film is made and the method for forming the film are factors which are involved in determining the life time of the semiconductor laser. Since, in a semiconductor laser, there are restrictions on the material of the antireflection film or on the method for forming the film, a material or method must be selected on the basis of experimental facts. Also, considering the difference in coefficient of thermal expansion between the film and the semiconductor laser, it is desirable to have an antireflection film with as small a number of layers as possible.

The smallest number of layers for obtaining reflectivity useful for the purpose of an antireflection film is "2". For example, an antireflection film of two-layered structure comprising respective optical films of high and low refractive indexes is derived from computing an optical propagation constant of a semiconductor laser of 1.55 µm wavelength, in which the optical film of high refractive index has a refractive index of 2.44 and a thickness of 145 µm (1450 Å), and the optical film of low refractive index has a refractive index of 1.37 and a thickness of 275 µm (2750 Å). The reflectivity obtained by this antireflection film is 0.01% or less.

An optical film having a refractive index of 1.37 can be formed by an ordinary vacuum deposition method using an optical material such as lithium fluoride (LiF) or magnesium fluoride (MgF₂). However, an optical material which forms an optical film having a refractive index of 2.44 is as yet unknown. Although zinc selenium (ZnSe), which has a refractive index of 2.46, is used as a material having a refractive index near to 2.44, the refractive index of this material cannot be greatly changed.

On the other hand, a reflection film for forming the resonator of a semiconductor laser is required to have a low loss and a comparatively high reflectivity, so as to match the characteristics of the device.

In the technical field of lens coating, where visible light is mainly used, it is known that a high reflectivity with low loss can be obtained by combining a high-refractive-index optical film having a refractive index of 2.0 to 2.4, such as zinc sulphur (ZnS), cerium oxide (CeO₂), or zinc selenium (ZnSe), together with a low-refractive-index optical film having a refractive index of 1.35 to 1.47, such as silicon dioxide (SiO₂), MgF₂, or LiF.

However, because the wavelength of laser light is in the near infrared range, in the technical field of a semiconductor laser made of a compound semiconductor of the III to V groups, two conditions need to be satisfied. The first is that the high-refractive-index optical film has a refractive index higher than the above-mentioned refractive index of 2.0 to 2.4, and the second is that the optical films have little light absorption so as to obtain a high output. Therefore, the above-mentioned high refractive index materials are not optimal. Silicon (Si), germanium (Ge), and the like are known to satisfy the condition of having a high refractive index, and for example, there is known a high-reflectivity film of multi-layered structure in which a pair of Si and SiO₂ layers are respectively formed to a thickness of 1/4 wavelength. Although a reflection film of this type is used in a semiconductor laser, it does not fully satisfy the above-mentioned two conditions, because Si and Ge have a light absorption band in the near infrared range.

Although various improvements in crystal growing methods have been suggested for reducing light absorption of the Si layer, they have hardly brought any good results.

For example, growing a silicon film by means of deposition has the advantages that it causes little thermal damage to the semiconductor because of the formation of the film at a low temperature, and that the film thickness can be precisely controlled by placing a film thickness gauge inside the chamber. On the contrary, the method has the disadvantage that the silicon film has a high light absorption because it is polycrystalline.

Although growing a silicon film by means of CVD can stably make a specified film quality, it damages the semiconductor because it is a high-temperature process.

Even if there were a low temperature process for improving the crystallinity of a silicon layer used as a high-refractive-index layer in a multi-layered reflection film, the silicon interferes with the laser oscillation when it comes in contact with the p-n junction interface of the semiconductor laser. This is because the silicon has a higher electric conductivity than a dielectric such as glass.

As mentioned above, because a semiconductor laser does not give a desired performance when a specified refractive index cannot be obtained for a high-refractive-index layer used to form a multi-layered antireflection film or reflection film, a material of an optical film having a refractive index optimal for improving its performance or a method for forming such an optical film is desired.

Also, the optimal refractive index of an optical film forming an antireflection film or reflection film to be used for a semiconductor optical device does not have only one value, but needs to be changed according to the structure of the optical waveguide of the semiconductor laser. Therefore, a technique capable of freely adjusting the refractive index of the antireflection film or reflection film is desired.

EP-A-536607 discloses a multilayer coating for maintaining a metallic appearance, where one layer can be of titanium oxynitride with a protective layer next to this layer. The protective layer may have a lower refractive index than the titanium oxynitride layer.

According to a first aspect of the present invention, there is provided a multi-layered anti-reflection or reflection optical film, comprising:
a high-refractive-index quarter wavelength layer composed of titanium oxynitride, aluminum oxynitride or silicon oxynitride; and
a low-refractive-index quarter wavelength layer positioned next to the high-reflective-index quarter wavelength layer.

Preferably, the high-refractive-index layer has a refractive index in the range of from 2.2 to 4.0. Where the high-refractive-index layer is in an anti-reflection film, it preferably has a refractive index in the range of from 2.8 to 4.0. Where the high-refractive-index layer is in a reflection film, it preferably has a refractive index in the range of from 2.2 to 2.8.

The low-refractive-index layer may be composed of magnesium fluoride, lithium fluoride or silicon dioxide.

In a second aspect, the invention provides a semiconductor laser having a multi-layered anti-reflection or reflection optical film according to the first aspect of the invention.

According to a third aspect of the present invention, there is provided a method for forming an anti-reflection film, comprising:
forming a high-refractive-index quarter wavelength layer composed of titanium oxynitride, aluminum oxynitride or silicon oxynitride by means of an ion assist deposition method; and
forming a low-refractive-index quarter wavelength layer positioned next to the high-reflective-index quarter wavelength layer.

In this method, the ion assist deposition method preferably comprises: vaporising a raw material of the high-refractive-index layer by irradiating electrons from an electron gun onto the raw material; and, at the same time, ionising a gaseous element inside an ion gun and ionising a different gaseous element outside the ion gun; and bonding the ionized gaseous elements together with the vaporised raw material. The gaseous element ionised inside the ion gun may be oxygen and the gaseous element ionised outside the ion gun may be nitrogen.

According to a fourth aspect of the present invention, there is provided a method for forming a reflection film, comprising:
forming a low-refractive-index quarter wavelength layer;
forming, by means of an ion assist deposition method, a high-refractive-index quarter wavelength layer composed of titanium oxynitride, aluminum oxynitride or silicon oxynitride, positioned next to the low-reflective-index layer.

In the method of the fourth aspect, the ion assist deposition method preferably comprises: vaporising a raw material of the high-refractive-index layer by irradiating electrons from an electron gun onto a block of the raw material; and, at the same time, ionizing a gaseous element, preferably nitrogen, by an ion gun; and bonding the ionized gaseous element together with the vaporised raw material.

In the methods of the third and fourth aspects of the invention, the refractive index of the high-refractive-index layer may be adjusted by changing the deposition rate of the high-refractive-index layer. The deposition rate of the high-refractive-index layer may be changed by changing the electric current supplied to the electron gun by which the raw material is irradiated.

Embodiments of the present invention can provide an optical film having a high-refractive-index layer whose refractive index can be changed over a wide range according to its growth conditions, and can provide a method for forming the optical film and an optical device having the optical film.

In certain embodiments, the present invention provides a multi-layered optical film with a high-refractive-index layer.

The refractive index of a titanium oxynitride film can be adjusted to be in the range of from 2.2 to 4.0 by properly choosing the conditions of the ion assist deposition method. Since its growth temperature is as low as that of silicon, the process of growing the film does not affect the characteristics of the semiconductor optical device to which it is applied. Moreover, the titanium oxynitride film is a dielectric film and thus does not cause electric current to leak when it is formed on a p-n junction interface of a semiconductor optical device. Furthermore, since the light absorption by its crystal is less than that of silicon and is as little as that of ZnSe, attenuation in intensity of the optical input and output of the optical device is suppressed.

Therefore, the light emission or light detection by the optical device results in being precisely controlled by forming a multi-layered optical film having an optimal refractive index for each of various optical devices.

For a better understanding of the invention, and to show how the same may be carried into effect, reference will now be made, by way of example, to the accompanying drawings, in which:-
Figure 1 is a diagrammatic view of an ion assist deposition apparatus used for forming an optical film of the present invention;
Figure 2 is a graph showing the relationship between deposition rate and refractive index of a TiON film formed by means of an ion assist deposition method;
Figure 3 is a graph showing the relationship between ion current and refractive index of an optical film formed by means of an ion assist deposition method;
Figure 4 is a graph showing the relationship between the ratio of oxygen in an oxygen-nitrogen mixed gas and the refractive index when an optical film is formed by means of an ion assist deposition method;
Figure 5 is a graph showing the relationship between the deposition rate and refractive index of an optical film formed by means of a method in accordance with the present invention;
Figure 6 is a cross-sectional view of a semiconductor laser in accordance with the present invention;
Figure 7 is a graph showing the relationship between temperature and the percentage of the accumulated number of semiconductor lasers with deteriorated characteristics in a humidity test for an optical film in accordance with the present invention and an optical film of the prior art;
Figure 8 is a diagrammatic perspective view of a semiconductor optical device according to an embodiment of the present invention;
Figure 9 is a graph showing the relationship between ionizing current and refractive indexes of optical films respectively in the cases applying only ionized nitrogen to a substrate, applying ionized nitrogen and oxygen to a substrate, in an ion assist deposition method used in forming optical films of the present invention; and
Figure 10 is a diagrammatic cross-sectional view of a semiconductor laser according to another embodiment of the present invention.

Instead of ZnS, CeO₂, ZnSe, Si, Ge and the like, the present inventors have used titanium oxynitride (TiON), and other oxygen and nitrogen dielectric compounds, as the material of high-refractive-index optical films used in a multi-layered reflection film or a multi-layered antireflection film.

As a method for forming oxynitride, the inventors used an ion assist deposition method which keeps low the temperature of the ground layer on which the oxynitride is to be deposited. It also gives a very good adhesion between the TiON film and the ground layer, and makes it easy to adjust the refractive index of the TiON film. The ion assist deposition method is a method for forming a film by irradiating ions of plural elements onto a substrate.

When using an ion assist deposition method for forming an optical film, two methods for controlling the refractive index are (1) adjusting the refractive index of the optical film by increasing the filling degree of the optical film by irradiating ions of a component element of the optical film onto the grown optical film, and (2) adjusting the refractive index of the optical film by changing the composition ratio of elements composing the optical film. The "filling degree" relates to the number of holes existing in an atomic unit inside an optical film formed by deposition; the larger the filling degree, the smaller the number of holes.

Method (1) can adjust the refractive index over a more narrow range, while method (2) can adjust the refractive index over a wider range.

The present inventors have found a method of forming an optical film having a TiON film or other oxygen and nitrogen compound film by means of an ion assist deposition method, and a method of applying the optical film to an optical device such as a light detecting device, a light emitting device, and an optical modulator, or to optical parts such as optical fibres and lenses. The methods are described in detail in the following.

Before describing optical films according to the invention, the construction of an ion assist deposition apparatus used for forming the optical films will be described in brief.

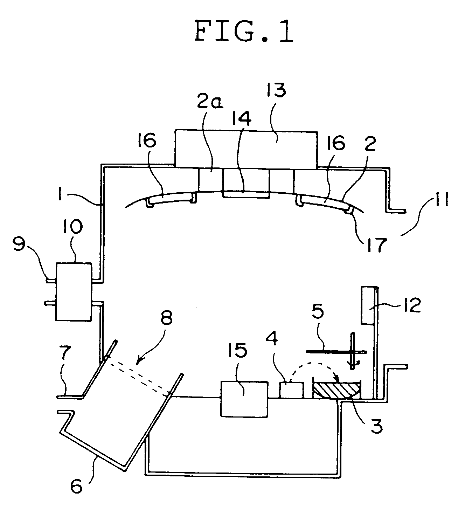

Referring to Figure 1, on the ceiling of a deposition chamber 1 is a rotary dome 2 (substrate supporting plate) used to hold substrates 16 on its lower face and arranged to be turned by a revolving part 2a. In one corner of the bottom of the deposition chamber 1, a cartridge type crucible 3 for containing a raw material is set opposite to the substrate supporting face of the rotary dome 2. A shutter 5, which can freely open and close, is located over the crucible 3, and an electron gun 4 for irradiating electrons onto the raw material in the crucible 3 is located next to the crucible 3. In another corner of the bottom of the deposition chamber 1, a Kaufmann type ion gun 6 (whose gas discharging outlet is 80 mm in diameter and 1100 mm from the centre of the rotary dome 2) is set opposite the substrate supporting face of the rotary dome 2. This ion gun 6 introduces gas through a first gas intake 7, ionizes the gas with thermal electrons from a filament (not shown), and discharges the ionized gas towards the rotary dome 2 by a voltage applied to an ion accelerating electrode 8.

A second gas intake 9 is formed in the side wall of the deposition chamber 1 between the ion gun 6 and the rotary dome 2. The flow of gas introduced through the second gas intake 9 is adjusted by means of an automatic pressure regulator 10. An exhaust outlet 11 is formed in the side wall of the deposition chamber 1 opposite to the second gas intake 9, and a deposition rate monitor 12 of the crystal oscillator type is located near the exhaust outlet 11 and the shutter 5.

On the middle part of the upper face of the rotary dome 2 is provided a first film thickness monitor 13 of the photoelectric type for monitoring film thickness with a reflected light. Monitor 13 monitors the thickness of the film formed on a glass monitoring substrate 14 which is set on the lower face of the middle part of the rotary dome 2. Opposite to the first film thickness monitor 13 and between the ion gun 6 and the electron gun 4 is provided a second film thickness monitor 15 of the photoelectric type. This measures the thickness of the film on the surface of the glass monitoring substrate 14 on the basis of a light which has been transmitted through the glass substrate 14. The source of the transmitted light is inside the first film thickness monitor 13. The reflected light has a wavelength of 0.65 µm and the transmitted light has a wavelength of 1.55 µm.

A holder 17 holds the substrate 16 on the lower face of the rotary dome 2.

Film forming methods are described in the following. The first to third methods are for forming a high-reflective-index layer of an antireflection film, and the remaining methods are for forming a high-refractive-index layer of a reflection film.

### First Embodiment

This method is for forming an optical film by means of the above-mentioned ion assist deposition apparatus, and makes a high-refractive-index optical film of TiON which is to be used in a two-layered antireflection film for a semiconductor laser having a wavelength of 1.55 µm, for example. It is desired to control the refractive index of the high-refractive-index optical film to be in the range of from 2.50 to 2.60 to make it function as an antireflection film at that wavelength.

First, substrates 16 to have an optical film formed thereon are mounted on the lower face of the rotary dome 2 around the glass monitoring substrate 14. A cartridge type crucible 3 filled with Ti₃O₅ is placed in the deposition chamber 1, and the gas inside the deposition chamber 1 is exhausted through the exhaust outlet 11. Oxygen (O₂) gas is then introduced into the ion gun 6 through the first ionizing gas intake 7, and an ionizing current of 20 mA is run in the ion gun 6 by applying a voltage of 1 kV to the ion accelerating electrode 8. The oxygen ionized by this is discharged inside the deposition chamber 1.

Then nitrogen (N₂) gas is introduced into the deposition chamber 1 through the second gas intake 9. The flow rate of the nitrogen gas is controlled by the automatic pressure regulator 10, so that the pressure inside the deposition chamber 1 is kept at 4.5 x 10⁻³ Pa.

Furthermore, by using a magnetic field to change its path by 180°, an electron beam emitted from the electron gun 4 is irradiated onto the Ti₃O₅ in the crucible 3. After vaporising the Ti₃O₅ in this way, the shutter 5 is opened to discharge the Ti₃O₅ vapour towards the lower face of the rotary dome 2.

A voltage of, for example, 6.0 kV is applied to an electrode inside the electron gun 4.

Thus, the vaporised titanium oxide and the ionized oxygen and nitrogen are supplied to the substrates 16 and the glass monitoring substrate 14 under the rotary dome 2 so that a TiON film is deposited at a deposition rate of 0.03 to 0.1 µm/sec (0.3 to 1.0 Å/sec). The deposition rate can be controlled by the electric current applied to the electron gun 4.

Growth of the TiON film is detected by the photoelectric film thickness monitor 13 on the rotary dome 2. The film thickness monitor 13 has a light source and a light detector, and light emitted from the light source is reflected by the TiON film deposited on the surface of the glass monitoring substrate 14. The amount of reflected light is detected by the light detector, and the film thickness is obtained on the basis of the amount of reflected light.

The film thickness is also detected by the photoelectric type film thickness monitor 15.

Some of the material vaporised from the crucible 3 is deposited on a crystal plate inside the crystal oscillator type deposition rate monitor 12, and the deposition rate is measured on the basis of the variation in frequency of the crystal plate caused by the increase in the amount of deposited material.

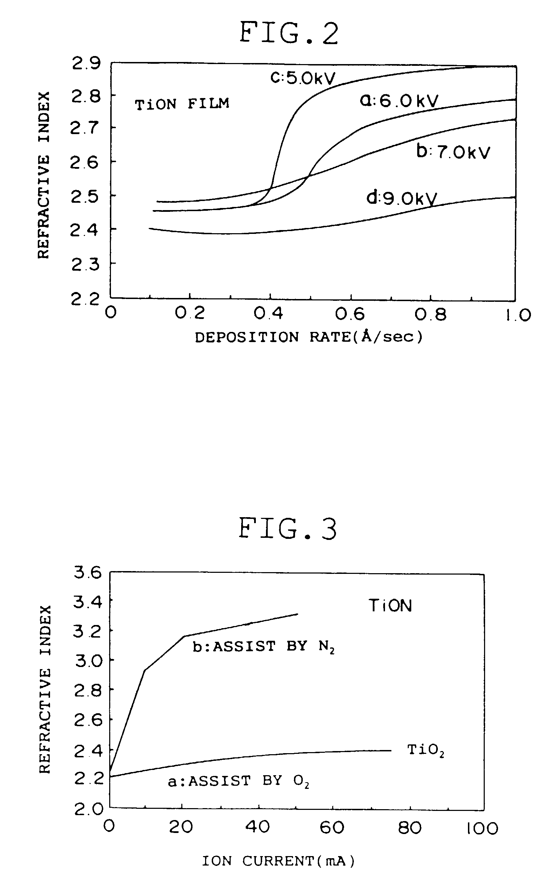

In an experiment carried out according to this first method, a curve showing the relationship between deposition rate and refractive index was obtained and is shown as curve a in Figure 2, where the axis of abscissa shows the deposition rate of an optical film made of TiON and the axis of ordinate shows the refractive index of the film.

Supposing that the refractive index necessary for the optical film is 2.55 and the effective range of its variation (error) is ± 0.05, the deposition rate must be controlled within the comparatively narrow range of 0.044 to 0.051 µm/sec (0.44 to 0.51 Å/sec). Refractive indexes shown in the following are values measured on the basis of the wavelength of visible light, unless specified in particular.

Next, the relationship between the deposition rate and the refractive index when using the voltage applied to the electron gun 4 as a parameter is described on the basis of Figure 2.

Curve a in Figure 2 shows the result of measuring the refractive index when a fixed voltage of 6.0 kV is applied to the electron gun 4 and the deposition rate of the TiON film is varied by changing the electric current flowing in the electron gun 4. The result is that there is a range of deposition rates in which the refractive index of the TiON film can be greatly varied.

Curve b in Figure 2 shows the variation in a refractive index when the voltage applied to the electron gun 4 is fixed at 7.0 kV and the deposition rate of the TiON film is changed by varying the electric current flowing in the electron gun 4. It can be seen that the variation of refractive index of the TiON film in curve b is less influenced by the deposition rate and is kept at a lower level than that in curve a. As a result, in the case of making a film having a refractive index of 2.55 and an effective variation range of ± 0.05, the necessary control range of the deposition rate is as wide as 0.03 to 0.06 µm/sec (0.30 to 0.60 Å/sec). Thus, the refractive index of the film may be more easily controlled because of the lesser influence of the deposition rate on the variation in the refractive index.

Curves c and d in Figure 2 show the limits of the adjustment of the voltage of the electron gun 4.

Curve c shows the variation in the refractive index when the voltage applied to the electron gun 4 is fixed at a 5.0 kV and the deposition rate is varied by changing the electric current flowing in the electron gun 4. In this case, it can be seen that it is difficult to achieve a refractive index of 2.55 within an effective range of ± 0.05, because the refractive index changes sharply according to the variation of the deposition rate. Thus, when growing a TiON film in the range of deposition rates where its refractive index changes sharply by applying a voltage such as this to the electron gun 4, the refractive index of the optical film has a poor repeatability and the film has various refractive indexes. Such undesirable qualities are also liable to occur when the applied voltage is lower than 6.0 kV.

Curve d shows the variation in the refractive index when the voltage applied to the electron gun 4 is fixed at 9.0 kV and the deposition rate is varied by changing the electric current flowing the electron gun 4. In this case, the refractive index changes more gently as compared with curve b, but does not give a refractive index of 2.50 even at a deposition rate of 0.1 µm/sec (1.0 Å/sec).

Thus, it can be seen that the higher the voltage applied to the electron gun 4, the less the refractive index is influenced by the deposition rate. On the other hand, in the case where the voltage applied to the electron gun 4 is too high, the range over which the refractive index of the optical film can be adjusted is narrow and it is difficult effectively to adjust the refractive index. It has been found that there is an optimal range for the voltage applied to the electron gun 4 for controlling a deposition rate by means of the electric current flowing the electron gun 4.

In the case that the voltage applied to the electron gun 4 is fixed in the range of from 6.0 kV to 8.0 kV, the refractive index of the optical film can be controlled with improved controllability. Thus, an optical film having a desirable refractive index can be easily formed.

The above-mentioned conditions also can be applied to adjusting the refractive index of an optical film of an aluminum-oxygen-nitrogen compound, a silicon-oxygennitrogen compound, and other oxygen-nitrogen compounds.

This method provides a method of adjusting the refractive index of a TiON film by formed means of an ion assist deposition method by setting the voltage applied to the electron gun in a range where the refractive index does not vary greatly depending upon the deposition rate. In this case, it is also possible to adjust the refractive index of the optical material itself by varying the ion ratio of oxygen to nitrogen in addition to the raw material of the optical film used to form the optical film on a substrate.

### Second Embodiment

In the first method, when forming a high-refractive-index layer of an antireflection film of a semiconductor laser of 1.55 µm wavelength, only oxygen gas is introduced through the ion gun 6. This is for improving the controllability of the refractive index. The detailed reason is described in the following.

Up to now, one object of forming a film by means of the ion assist deposition method is to improve the adhesion of the film without heating the substrate. This property is particularly attractive in the case of forming a film for a semiconductor device.

This method has the effect of making the refractive index of the film greater. The refractive index of the optical film is adjusted as described above. Figure 3 shows the relationship between ion current of the ion gun 6 and the refractive index of an optical film of TiON formed by means of an ion assist deposition method. The axis of abscissa shows the ion current and the axis of ordinate shows the refractive index of the grown optical film.

According to curve a in Figure 3, because the raw material Ti₃O₅ is turned into TiO₂ by taking in oxygen due to irradiation of oxygen ions inside the crucible 3, it is found that the refractive index of the optical film changes little even when the ion current is increased. Little nitrogen gas is introduced through the second gas intake 9.

When this method is used for forming an optical film of a semiconductor laser, if the intensity of ion irradiation is increased too much for the purpose of increasing the ion current, sufficient energy cannot be given because of the possibility of damaging the semiconductor laser. Therefore, an optical film having the necessary refractive index may not be obtained.

To compensate for this problem, it is thought that a compound different from the raw material could be formed by intentionally irradiating ions not contained in the raw material in the crucible 3. According to this, it is possible greatly to change the refractive index by changing the amount of ions. For example, when forming a TiON film by irradiating nitrogen ions onto the raw material T1₃O₅, the refractive index of the TiON film varies greatly, as shown by curve b in Figure 3.

Thus, the refractive index can be varied greatly by implanting ions of an element, namely nitrogen, different from the raw material, in addition to the raw material Ti₃O₅.

However, as seen from curve b, the refractive index increases sharply with the increase in ion current when the ion current is near 20 mA. Therefore, it is not easy to control the refractive index in the range of from 2.45 to 2.90, for example.

Then, when the present inventors carried out an ion assist operation in which nitrogen and oxygen were introduced into the ion gun 6 at the same time in addition to vaporising Ti₃O₅ from the crucible 3, it was found that it was difficult for oxygen to be implanted into the Ti₃O₅ and the refractive index of the optical film could not be changed greatly. The reason is thought to be that nitrogen is ionized more greatly than oxygen.

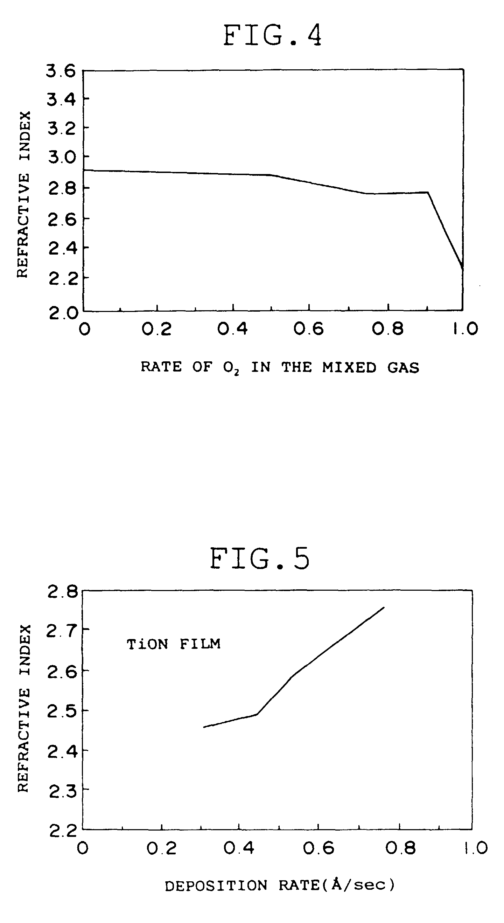

Furthermore, when an experiment was conducted in which a TiON film was formed and the ratio of oxygen contained in a mixed gas of oxygen and nitrogen was changed, the refractive index of the film changed greatly when there was 90% or more of oxygen in the mixed gas, as shown in Figure 4. Here the axis of abscissa shows the ratio of oxygen contained in the mixed gas of nitrogen and oxygen and the axis of ordinate shows the refractive index of the optical film.

When the bonding state of nitrogen and oxygen ions in an optical film was controlled by introducing a gas to be comparatively intensely ionized, such as nitrogen, through only the second gas intake 9 distant from the ion gun 6, and introducing a gas to be comparatively gently ionized, such as oxygen, into the ion gun 6, the experimental result shown in Figure 5 was obtained. Here, the axis of ordinate shows the refractive index and the axis of abscissa shows the deposition rate. The deposition rate is controlled by changing the electric current of the electron gun 4.

It is confirmed from the curve in Figure 5 that the refractive index of the optical film varies gently and linearly over a wide range of deposition rates.

As shown from this result, oxygen is ionized by thermal electrons emitted from a filament inside the ion gun 6 and the oxygen ions are accelerated by a voltage applied to ion accelerating electrode 8. The oxygen ions then ionize the nitrogen introduced through the second gas intake 9 of the deposition chamber to grow a TiON film on the substrates 16. In this case, the refractive index of the film is determined by the bonding state of the nitrogen and oxygen ions implanted into the TiON film, and the bonding state is adjusted by changing the deposition rate.

According to a method such as this, because the refractive index of the grown optical film is not influenced by a variation in the ion current, an optical film is formed by a gentle ion irradiation and damage to a semiconductor laser can be reduced.

Utilising the above-mentioned technology, a process for forming a high-refractive-index layer comprising a two-layered antireflection film applied to a semiconductor laser of 1.55 µm wavelength will now be described. The two-layered antireflection film comprises a low-refractive-index optical film having a refractive index of 1.37 and a high-refractive-index optical film having a refractive index of 2.44.

First, the crucible 3 is filled with a raw material T1₃O₅ and is mounted inside the deposition chamber 1. Next, a glass monitoring substrate 14 for measuring the thickness of a deposited film is set in the middle of the lower face of the rotary dome 2, and a plurality of substrates 16 are set around the glass substrate 14. The rotary dome 2 is revolved at a speed where irregularities in distribution of deposition flow on the surface of each substrate are so little as to be negligible. Concretely speaking, each of the substrates 16 is to be made into a semiconductor laser and an antireflection film is formed on its end face.

Next, the inside of the deposition chamber 1 is exhausted by rotary pump and mechanical booster pump (not shown) through the exhaust outlet 11 to a medium vacuum (1 x 10⁻² to 1 x 10⁻³ Pa), and then is exhausted by an cryopump (not shown) to a high vacuum of 1.5 x 10⁻⁴ Pa.

After this, when the vacuum of the deposition chamber 1 has reached the target value, oxygen is introduced at a flow rate of 10 sccm through the ionizing gas intake 7 so that the inside of the deposition chamber 1 is kept at a pressure of 2.6 x 10⁻³ Pa. Then nitrogen gas is introduced into the deposition chamber 1 through the second gas intake 9 with its flow rate being adjusted by means of the automatic pressure regulator 10 so that the inside of the chamber 1 is kept at a pressure of 4.5 x 10⁻³ Pa.

After this preparation for deposition has finished, thermal electrons emitted from the electron gun 4 are irradiated onto the raw material Ti₃O₅ inside the crucible 3.

The deposition rate is controlled by controlling the voltage applied to the electron gun 4 and changing electric current of the electron gun 4. Details of this are omitted here, since they were described in the first method.

When the deposition rate has reached the target value, a voltage of 1.0 kV is applied to the ion accelerating electrode 8 of the ion gun 6 to run an ion current of 20 mA inside the ion gun 6. The ion gun 6, which is of hot cathode type, ionizes the activated gas by colliding electrons against the activated gas (oxygen). Nitrogen, which is easy to ionize, is ionized above the ion gun 6 by electrons emitted from it. Thus, nitrogen ions are generated by generating oxygen ions in the ion gun 6 and then making them collide against the nitrogen gas. After performing this ionizing process for about 2 seconds, the shutter 5 over the crucible 3 is opened to start depositing a TiON film on the substrates 16.

The thickness of the TiON film deposited on the glass monitoring substrate 14 is monitored by means of the first and second film thickness monitors 13 and 15. At the same time, the rate of deposition of the TiON film is monitored by means of the deposition rate monitor 12.

In order to obtain an optical film having refractive index of 2.44, the deposition rate is set at 0.05 µm/sec (0.5 Å/sec) on the basis of Figure 5, for example. Because the refractive index shown in Figure 5 was measured with visible light having a wavelength of 0.63 µm, it was evaluated as 2.55 at a deposition rate of 0.05 µm/sec (0.5 Å/sec). However, it has been experimentally confirmed that the refractive index is evaluated as 2.44 when calibrating it with the light of a semiconductor laser which has a wavelength of 1.55 µm. Measurement of a refractive index by means of light of 1.55 µm wavelength is slightly shifted from the measurement of refractive index by means of visible light.

As a result of analyzing a grown TiON film using Fourier transform infrared absorption analysis method (FT-IR), it has been confirmed that there are O-N bonds in molecules of the TiON film and that they comprise a compound.

According to the results of the analysis, a TiON film grown by this optical film forming method has a spectrum where peaks appear at 490 cm⁻¹, 436 cm⁻¹, and 395 cm⁻¹ which show TiO₂ and TiN. Thus, it has been confirmed that the TiON film has an intermediate composition between TiO₂ and TiN, and has a composition where Ti-O-N and Ti-O-O-N and the like are bonded with each other because its spectrum has three peaks.

From the first and second embodiments, it is known that the refractive index of a TiON film can be easily controlled to be in the range of from 2.2 to 2.9.

### Third Embodiment

This embodiment relates to a method for forming an antireflection film of a semiconductor laser using a TiON film.

In order to make the best use of the functionality of a semiconductor laser, it is necessary very accurately to control its reflectivity and to keep its antireflection film at a reflectivity of 0.01 % or less.

A known antireflection film used in a semiconductor laser or the like comprises a multi-layered dielectric film which has plural dielectric films in it, each of which has thickness of 1/4 of the wavelength of the light reflection of which is to be prevented.

Hitherto, a multi-layered antireflection film comprising dielectric films has been made by layering plural dielectric films on a glass or plastics substrate. In the case of applying an antireflection film such as this to a semiconductor device such as a semiconductor laser, particularly to a compound semiconductor optical device, it has been known that there are limits to the adhesion of the antireflection film to a semiconductor layer, an inner stress of the film, its electric characteristics such as an interface level of a semiconductor substrate, a comprehensive life of a device, and the like.

An object of this embodiment is to provide an antireflection film which has a small number of optical films to grow, a good adhesion to a substrate, excellent electric characteristics of its contact face, and a long life. Namely a so-called antireflection film fit for a semiconductor substrate.

The least number of optical film layers necessary for attaining a reflectivity of 0.01 % or less is "2" which is attained by an existing technology. A known two-layered film is a combination of a ZnSe film and an MgF₂ film.

A semiconductor laser of 1.55 µm wavelength attains a two-layered antireflection film of 0.01 % reflectivity by having an optical film with a refractive index of 2.44 as the first layer and an optical film with a refractive index of 1.37 as the second layer.

However, as described above, ZnSe has two problems. Firstly, ZnSe cannot fully attain a refractive index of 2.42 to 2.44, even if it is required as the optimal refractive index according to a difference in the structure of semiconductor lasers. ZnSe has a refractive index of 2.46.

Secondly, ZnSe has a problem whether or not it is an adequate material as far as physical adhesion to a crystal of InP or InGaAsP, for example, comprising a semiconductor laser, stress, durability, electric characteristics in the contact face and the like are concerned. For example, ZnSe has such a great problem that, when an MgF₂ film is formed on a ZnSe film, the two films are liable to exfoliate from each other due to an internal stress generated between them when ZnSe is applied to a semiconductor laser.

An example of a semiconductor laser having an antireflection film, a part of which comprises an optical film good in controllability of its refractive index as described in the first and second embodiments, is described in the following.

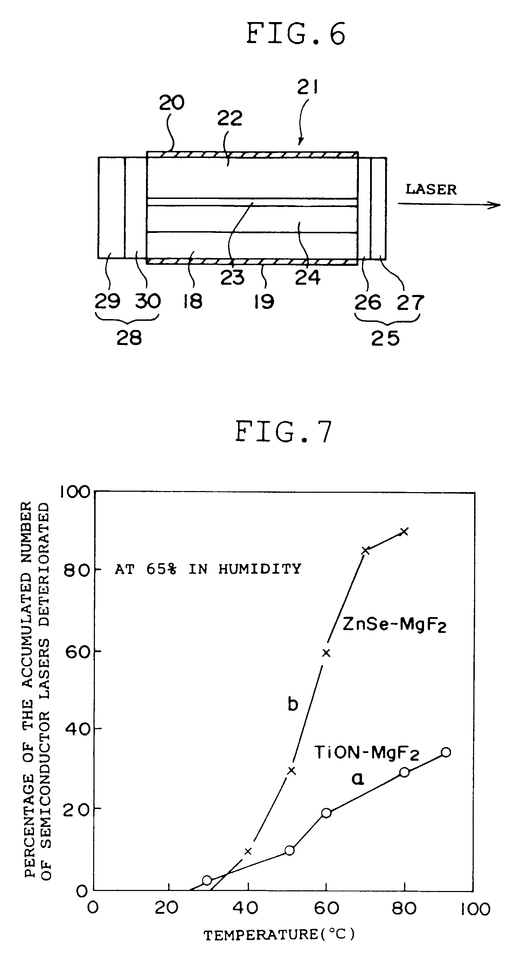

In Figure 6, a semiconductor laser 21 has an activated layer 23 held between two clad layers 22 and 24, and has an antireflection film 25 formed on one end thereof. The antireflection film 25 comprises a high-refractive-index optical film 26 and a low-refractive-index optical film 27. On the other end, the semiconductor laser 21 has a reflection film 28 which comprises a low-refractive-index optical film 30 and a high-refractive-index optical film 29. Reference numeral 18 shows a semiconductor substrate having the lower clad layer 24 formed thereon, 19 shows an electrode formed on the lower face of the semiconductor substrate 18, and 20 shows an electrode formed on the upper clad layer 22.

The high-refractive-index optical film 26 and the low-refractive-index optical film 27 which comprise the antireflection film 25 have refractive indexes of 2.44 and 1.37 respectively, and have a thickness which is 1/4 of the wavelength of the light whose reflection is to be prevented. The high-refractive-index optical film 26 is formed directly on one end face of the semiconductor laser 21. It has been found, by an ordinary optical computation, that these refractive indexes are optimal to the antireflection film to obtain a condition where the incident light and the reflected light are in reverse phase to each other.

This embodiment uses a TiON film of 2.44 refractive index as the high-refractive-index optical film 26 and an magnesium fluoride (MgF₂) film or a lithium fluoride (LiF) film as the low-refractive-index optical film 27 of the antireflection film 25. A method for forming the TiON film comprising the high-refractive-index optical film has already been described in the first and second embodiments. On the other hand, the high-refractive-index optical film 29 and the low-refractive-index film 30 which comprise the reflection film 28 have refractive indexes of 2.44 and 1.37 respectively, and have a thickness which is 1/4 of the wavelength of the light to be reflected. The low-refractive-index optical film 30 is formed directly on the other end face of the semiconductor laser 21. This embodiment uses a TiON film of 2.44 refractive index as the high-refractive-index optical film 29 and an MgF₂ or LiF or silicon dioxide (SiO₂) film as the low-refractive-index optical film 30. A method for forming the TiON film is described in the following.

Figure 7 is a graph showing the relationship between temperature and the percentage of the accumulated number of semiconductor lasers formed by the third embodiment with deteriorated characteristics in a humidity test. The axis of abscissa shows temperature (°C) and the axis of ordinate shows the percentage of the accumulated number of semiconductor lasers with deteriorated characteristics. This figure shows the percentage of the accumulated number of semiconductor lasers with deteriorated characteristics by exfoliation of the reflection film when the humidity is set at 65 % and the temperature is changed.

In Figure 7, curve a shows the percentage of the accumulated number of semiconductor lasers with deteriorated characteristics having TiON-MgF₂ films of this embodiment, and curve b shows the percentage of the accumulated number of semiconductor lasers with deteriorated characteristics having known ZnSe-MgF₂ films.

As clearly shown by curves a and b, the percentage of the accumulated number of semiconductor lasers with deteriorated characteristics having the antireflection film 25 of TiON-MgF₂ of this embodiment in relation to temperature is greatly improved compared with that of semiconductor lasers having the ZnSe-MgF₂ films.

It is found by observing the antireflection films by means of a microscope that the TiON-MgF₂ films of this embodiment are only changed in colour instead of being exfoliated, while the ZnSe-MgF₂ films are exfoliated. This shows that the adhesive force of the ZnSe-MgF₂ films to a semiconductor layer is weaker compared to that of the TiON films. In this case, it is possible to form a TiON film which has a refractive index intermediate that of TiO₂ and TiN by making the TiON film intermediate in composition between TiO₂ and TiN. A detailed description of this is omitted here because it has already been described.

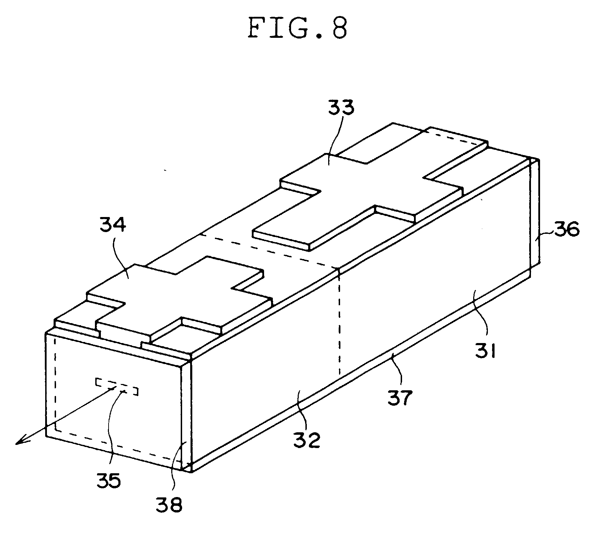

Figure 8 is a perspective view of a semiconductor optical device which has an optical modulator and a DFB laser integrated therein and has the above-mentioned antireflection film formed on it.

The DFB laser 31 and the optical modulator 32 comprise an InP crystal substrate and an InGaAsP layer grown thereon. The DFB laser 31 and the optical modulator 32 are divided from each other by an InP high-resistance layer, and respectively have upper electrodes 33 and 34 comprising three layers of Ti, Pt, and Au, as well as a common lower electrode 37 comprising two layers of AuGe and Au. An optical output end 35 of the optical modulator 32 is covered with an antireflection film 38 comprising two layers of TiON and MgF₂, and the end face of the DFB laser 31 opposite to the antireflection film 38 is covered with a reflection film 36.

The DFB laser 31 has a diffraction grating along the activated layer, and a single mode laser light emitted from its output end is introduced into the optical modulator 32 and is modulated in its waveguide. The optical modulator 32 has a construction for utilising the Franz-Keldysh effect so that the light inside the waveguide is absorbed by reduction of the band gap of the semiconductor layer caused by a high electric field generated by a voltage applied between the upper electrode 34 and the lower electrode 37. The laser light is modulated by variation of the voltage applied to the optical modulator 32.

Whether or not the antireflection film 38 formed on the end face of the optical modulator 32 has an excellent performance influences the degree that the laser light is single mode. Even if the antireflection film 38 satisfies the condition of 0.01 % or less reflectivity, mode change in modulation (chirping) and controllability of the primary mode are varied between the case of using an optical film such as ZnSe slightly shifted in refractive index from a desired value and the case of using a TiON film exactly matched in refractive index with the desired value by controlling its refractive index.

This problem appears as an increase in the error bit rate in an actual optical communication system.

The TiON film comprising the two-layered antireflection film 38, as described above, is formed by irradiating nitrogen ions and oxygen ions onto a semiconductor substrate, as well as irradiating T1₃O₅ vaporised by an electron beam onto the semiconductor substrate.

Because the refractive index of the TiON film is determined by the bonding state of the introduced oxygen and nitrogen ions, the refractive index of the TiON film can be controlled to be in the range of from 2.2 to 2.9 by changing the bonding state by adjusting its deposition rate. In this way, a high-refractive-index optical film of 2.44 refractive index is obtained with a film thickness of 145 µm (1450 Å).

The low-refractive-index optical film is obtained by forming a 275 µm (2750 Å) thick MgF₂ film on the TiON film by means of an ordinary electron beam deposition method using MgF₂ as the raw material inside the same deposition chamber.

The antireflection film 38 made in this manner had a reflectivity of 0.01 %, and its semiconductor laser was satisfactory in modulator characteristics.

Such an antireflection film may be applied to the light receiving face of a light detecting device or other semiconductor optical devices, in addition to a semiconductor laser. The TiON film shows optical absorption of the same degree as ZnSe.

### Fourth Embodiment

In the above-mentioned third embodiment, the use of TiON film of 2.2 to 2.9 refractive index as the high-refractive-index optical film of an antireflection film was described. However, when using TiON for a high-refractive-index optical film of a multi-layered reflection film, the TiON growing method as described above cannot be adopted as it is, because a refractive index of 3.0 or more is needed, according to optical theory. A TiON film is a dielectric film and does not interfere with the oscillation of a semiconductor laser, has little optical absorption made by its crystal and can be formed at a low temperature. It can be applied to a reflection film if it has a refractive index of 3.0 or more.

The inventors have found that a TiON film of 3.0 or more refractive index can be obtained using an ion assist deposition method by introducing only nitrogen gas into the deposition chamber 1 through the second gas intake 9 and into the ion gun 6, and then bonding nitrogen ions with particles to be deposited from the crucible 3. According to this method, an optical film which is equivalent to Si or Ge in refractive index and has very little optical absorption in the range of near infrared has been formed.

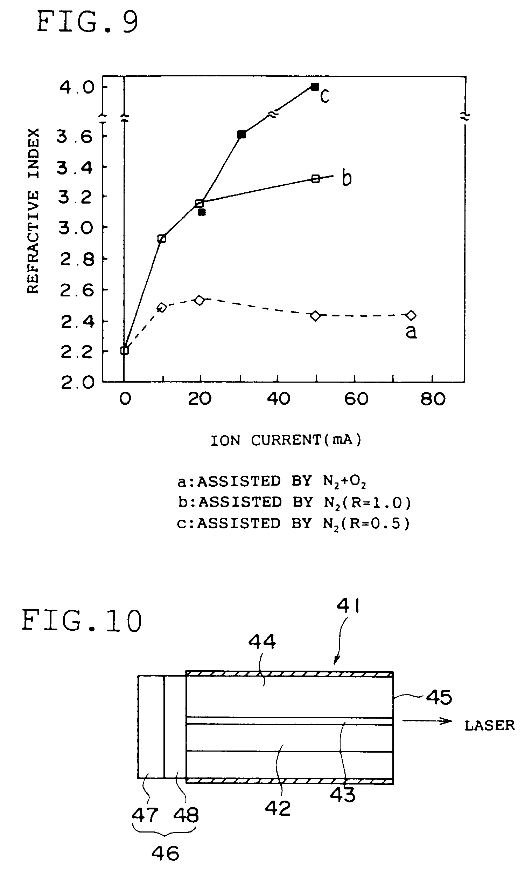

Figure 9 shows the effect of this method in which only nitrogen ions are irradiated, where the axis of abscissa shows the electric current applied to the ion gun 6 and the axis of ordinate shows the refractive index of the TiON film.

Curve a shows the result of measuring the refractive index when changing the deposition rate by changing the amount of electric current applied to the ion gun 6 when oxygen and nitrogen ions are irradiated at the same time.

The refractive index reaches a peak when the electric current of the ion gun 6 is 20 mA and the refractive index varies little even if the current is further increased. The reason is that ionizing energy for ionizing the oxygen and nitrogen is given by energy of ion irradiation, and becomes saturated when it exceeds a peak energy determined according to the kind of activated gas.

Curve b shows that ions to be bonded with TiO can be limited to only nitrogen by irradiating only nitrogen ions, and that the refractive index is raised by increasing the nitrogen content of the TiON film. The reason why the refractive index is raised when the electric current of the ion gun 6 becomes greater than 20 mA is that, because ions of only one element (nitrogen) are irradiated, the nitrogen ions are more intensely implanted into the film and so the filling degree of the TiON film is increased.

The inventors have found that the range of adjusting the refractive index is made wider by adjusting the scattering speed of particles of the starting material vaporised from the crucible 3. When the electric current being run in the ion gun 6 was set at 50 mA and the deposition rate was increased by changing the current of the electron gun 4, a refractive index of 4.0 was obtained. Curve c shows that the filling rate of the film is increased and the range of adjusting the refractive index is widened by reducing the electric current of the electron gun 4 when the deposition rate R is set at 0.05 µm/sec (0.5 Å/sec). In curve b, the deposition rate R is 0.1 µm/sec (1.0 Å/sec).

According to this embodiment, a reflection film is obtained by combining together a high-refractive-index TiON film formed by means of an ion assist deposition method where only nitrogen ions are irradiated, and a low-refractive-index optical film. Such a TiON film can be formed by means of the ion assist deposition apparatus shown in Figure 1. When forming a TiON film by means of this apparatus, only nitrogen gas is introduced into the deposition chamber 1 through the second gas intake 9 and into the ion gun 6. Nitrogen ions emitted from the ion gun 6 are bonded with particles vaporised from the crucible 3.

A high-refractive-index optical film composed of TiON is used for a laser light of 1.3 µm to 1.55 µm wavelength. In measuring its refractive index, a laser light of 0.63 µm wavelength was used. As described above, a refractive index of 2.55 for a light of 0.63 µm wavelength is slightly shifted to 2.44 for a laser light of 1.55 µm wavelength. In order to function as a multi-layered reflection film, it is desirable for the refractive index of the high-refractive-index optical film to be controlled in the range of from 3.4 to 3.8.

A method for forming a TiON film having such a refractive index is described in the following.

First, substrates 16 are mounted on the lower face of the rotary dome 2 and the cartridge type crucible 3 filled with Ti₃O₅ is set inside the deposition chamber 1. After this, the inside of the deposition chamber 1 is exhausted by a rotary pump and mechanical booster pump through the exhaust outlet 11 to a medium vacuum, and then is exhausted by a cryopump to a high vacuum of 1.5 x 10⁻⁴ Pa.

When the vacuum of the deposition chamber 1 has reached the target value, nitrogen gas is introduced through the first ionizing gas intake 7 and the flow rate of the nitrogen gas is adjusted by means of the automatic pressure regulator 10 so that the inside of the deposition chamber 1 is kept at a pressure of 4.5 x 10⁻³ Pa. After the above-mentioned preparation for deposition has finished, thermal electrons emitted from the electron gun 4 are irradiated onto the raw material Ti₃O₅ by bending a track of the thermal electrons by means of a magnetic field. In this case, the growth rate of the TiON film on the substrates 16 is controlled by controlling the electric current of the electron gun 4.

When the deposition rate has reached the target value, a voltage of 1.0 kV is applied to the ion accelerating electrode 8 of the Kaufmann-type ion gun 6 to run an ion current of 50 mA. 2 seconds after starting a nitrogen ion beam from the ion gun 6, the shutter 5 over the crucible 3 is opened to start deposition of TiON onto the substrates 16.

The thickness of the TiON film deposited on the glass monitoring substrate 14 is monitored by means of the first and second film photoelectric type thickness monitors 13 and 15, and the deposition rate of the TiON film is monitored by means of the crystal oscillator type deposition rate monitor 12.

A TiON film of 3.6 refractive index was formed by keeping the deposition rate at 0.05 µm/sec (0.5 Å/sec), and has an optical absorption in the range of near infrared less than an Si film.

It has been confirmed by an experiment that a TiON film having a refractive index in the range of from 2.8 to 4.0 can be formed by emitting only nitrogen ions from the ion gun 6 towards the substrates 16.

### Fifth Embodiment

This embodiment relates to a method for forming a reflection film of a semiconductor laser using a TiON film.

Figure 10 is a side view of a semiconductor laser of this embodiment, where the semiconductor laser 41 has an activated layer 43 held between two clad layers 42 and 44. A cleavage surface 45 is formed at one end face, which is to be the optical output end, and a multi-layered reflection film 46 is formed on a cleavage surface of the other end face. A resonator is composed of the cleavage surface 45 and the reflection film 46 and a semiconductor layer between them.

The reflection film 46 uses a TiON film of 3.6 refractive index as a high-refractive-index optical film 47 and an SiO₂ film as a low-refractive-index optical film 48. The films have a thickness of 1/4 of the wavelength of the light to be reflected, and the high-refractive-index optical film 47 is disposed outside the low-refractive-index optical film 48.

Although the TiON film is optically similar to a reflection film using Si or Ge, because TiON has a lower optical absorption than Si or Ge, the TiON film is better as the high-refractive-index optical film 47 of the multi-layered reflection film 45.

Dielectric material such as MgF₂ and LiF may alternatively be used as the low-refractive-index optical film 48.

According to the invention as described above, because a high-refractive-index layer of a multi-layered optical film such as a multi-layered antireflection or reflection film is made of oxynitride, it is possible precisely to control the characteristics of a semiconductor laser by applying the high-refractive-index layer to the semiconductor laser. The refractive index of the oxynitride can be controlled to be in the range of from 2.2 to 4.0 according to the conditions of the ion assist deposition method. By forming such an optical film on the optical input and output end faces of an optical part such as a light detecting device, a light emitting device, an optical filter device and the like, optical input and output performance can be improved in efficiency.

## Claims

1. A multi-layered anti-reflection or reflection optical film, comprising:
a high-refractive-index quarter wavelength layer (26;29;47) composed of titanium oxynitride, aluminum oxynitride or silicon oxynitride; and
a low-refractive-index quarter wavelength layer (27;30;48) positioned next to the high-refractive-index quarter wavelength layer.

2. An optical film as claimed in claim 1, wherein the high-refractive-index layer (26;29;47) has a refractive index in the range of from 2.2 to 4.0.

3. An optical film as claimed in claim 1 or claim 2, wherein the low-refractive-index layer (27;30;48) is composed of magnesium fluoride, lithium fluoride or silicon dioxide.

4. A semiconductor laser having a multi-layered anti-reflection or reflection optical film as claimed in claim 1, 2 or 3.

5. A method for forming an anti-reflection film, comprising:
forming a high-refractive-index quarter wavelength layer (26) composed of titanium oxynitride, aluminum oxynitride or silicon oxynitride by means of an ion assist deposition method; and
forming a low-refractive-index quarter wavelength layer (27) positioned next to the high-refractive-index quarter wavelength layer.

6. A method as claimed in claim 5, wherein the ion assist deposition method comprises: vaporising a raw material of the high-refractive-index layer (26) by irradiating electrons from an electron gun (4) onto the raw material; and, at the same time, ionising a gaseous element inside an ion gun (6) and ionising a different gaseous element outside the ion gun; and bonding the ionized gaseous elements together with the vaporised raw material.

7. A method as claimed in claim 6, wherein the gaseous element ionised inside the ion gun (6) is oxygen and the gaseous element ionised outside the ion gun is nitrogen.

8. A method for forming a reflection film, comprising:
forming a low-refractive-index quarter wavelength layer (30,48);
forming, by means of an ion assist deposition method, a high-refractive-index quarter wavelength layer (29,47) composed of titanium oxynitride, aluminum oxynitride or silicon oxynitride, positioned next to the low-refractive-index layer.

9. A method as claimed in claim 8, wherein the ion assist deposition method comprises: vaporising a raw material of the high-refractive-index layer (29,47) by irradiating electrons from an electron gun (4) onto a block of the raw material; and, at the same time, ionizing a gaseous element by an ion gun (6); bonding the ionized gaseous element together with the vaporised raw material.

10. A method as claimed in claim 9, wherein the gaseous element is nitrogen.

11. A method as claimed in claim 6, 7, 9 or 10, wherein the refractive index of the high-refractive-index layer (26;29;47) is adjusted by changing the deposition rate of the high-refractive-index layer (26;29;47).

12. A method as claimed in claim 11 when appended to claim 6 or to claim 9, wherein the deposition rate of the high-refractive-index layer (26;29;47) is changed by changing the electric current supplied to the electron gun (4) by which the raw material is irradiated.

## Patentansprüche

1. Mehrschichtiger optischer Antireflexions- oder Reflexionsfilm, der folgendes aufweist:
eine Viertelwellenlängenschicht mit hohem Brechungsindex (26; 29; 47), die aus Titanoxinitrid, Aluminumoxinitrid oder Siliziumoxinitrid zusammengesetzt ist; und
eine Viertelwellenlängenschicht mit niedrigem Brechungsindex (27; 30; 48), die neben der Viertelwellenlängenschicht mit hohem Brechungsindex angeordnet ist.

2. Ein optischer Film nach Anspruch 1, wobei die Schicht mit hohem Brechungsindex (26; 29; 47) einen Brechungsindex im Bereich von 2,2 bis 4,0 aufweist.

3. Ein optischer Film nach Anspruch 1 oder 2, wobei die Schicht mit niedrigem Brechungsindex (27; 30; 48) aus Magnesiumfluorid, Litiumfluorid oder Siliziumdioxid aufgebaut ist.

4. Halbleiterlaser mit einem mehrschichtigen optischen Antireflexions- oder Reflexionsfilm nach Anspruch 1, 2 oder 3.

5. Verfahren zum Bilden eine Antireflexionfilms, das folgende Schritte aufweist:
Bilden einer Viertelwellenlängenschicht mit hohem Brechungsindex (26), die aus Titanoxinitrid, Aluminiumoxinitrid oder Siliziumoxinitrid aufgebaut ist, durch ein ionenunterstütztes Auftragsverfahren; und
Bilden einer Viertelwellenlängenschicht mit einem niedrigen Brechungsindex (27), die neben der Viertelweilenlängenschicht mit hohem Brechungsindex angeordnet ist.

6. Verfahren nach Anspruch 5, wobei das ionenunterstützte Auftragsverfahren folgende Schritte aufweist: Verdampfen eines Rohmaterials der Schicht mit hohem Brechungsindex (26) durch Aufstrahlen von Elektronen aus einer Elektronenkanone (4) auf das Rohmaterial; und gleichzeitig lonisieren eines gasförmigen Elements innerhalb einer lonenkanone (6) und lonisieren eines anderen gasförmigen Elements außerhalb der lonenkanone; und Verbinden der ionisierten gasförmigen Elemente zusammen mit dem verdampften Rohmaterial.

7. Verfahren nach Anspruch 6, wobei das gasförmige Element, das innerhalb der lonenkanone (6) ionisiert worden ist, Sauerstoff ist und das gasförmige Element, das außerhalb der lonenkanone ionisiert worden ist, Stickstoff ist.

8. Verfahren zum Bilden eines Reflexionsfilms, das folgende Schritte aufweist:
Bilden einer Viertelwellenlängenschicht mit niedrigem Brechungsindex (30, 48);
Bilden einer Viertelwellenlängenschicht mit hohem Brechungsindex (29, 47), die aus Titanoxinitrid, Aluminiumoxinitrid oder Siliziumoxinitrid aufgebaut ist, die neben der Schicht mit niedrigem Brechungsindex angeordnet ist, durch ein ionenunterstützes Auftragsverfahren.

9. Verfahren nach Anspruch 8, wobei das ionenunterstützte Auftragsverfahren folgende Schritte aufweist: Verdampfen eines Rohmaterials der Schicht mit hohem Brechungsindex (29, 47) durch Aufstrahlen von Elektronen aus einer Elektronenkanone (4) auf einen Block des Rohmaterials; und gleichzeitig lonisieren eines gasförmigen Elements durch eine lonenkanone (6); und Verbinden der ionisierten gasförmigen Elemente zusammen mit dem verdampften Rohmaterial.

10. Verfahren nach Anspruch 9, wobei das gasförmige Element Stickstoff ist.

11. Verfahren nach Ansprüchen 6, 7, 9 oder 10, wobei der Brechungsindex der Schicht mit hohem Brechungsindex (26; 29; 47) durch Änderung der Ablagerungsgeschwindingkeit der Schicht mit hohem Brechungsindex (26; 29; 47) eingestellt wird.

12. Verfahren nach Anspruch 11, in Verbindung mit Anspruch 6 oder 9, wobei die Ablagerungsrate der Schicht mit hohem Brechungsindex (26; 29; 47) durch Änderung des elektrischen Stroms, der der Elektronenkanone (4) zugeführt wird, durch die das Rohmaterial bestrahlt wird, geändert wird.

## Revendications

1. Film optique antiréfléchissant ou réfléchissant multicouche, comprenant :
une couche d'indice élevé de réfraction d'un quart de la longueur d'onde (26 ; 29 ; 47) composée d'oxynitrure de titane, d'oxynitrure d'aluminium ou d'oxynitrure de silicium, et
une couche de faible indice de réfraction d'un quart de la longueur d'onde (27 ; 30 ; 48) placée à côté de la couche d'indice élevé de réfraction d'un quart de la longueur d'onde.

2. Film optique selon la revendication 1, dans lequel la couche d'indice de réfraction élevé (26 ; 29 ; 47) a un indice de réfraction compris entre 2,2 et 4,0.

3. Film optique selon la revendication 1 ou 2, dans lequel la couche de faible indice de réfraction (27 ; 30 ; 48) est composée de fluorure de magnésium, de fluorure de lithium ou de silice.

4. Laser à semi-conducteur ayant un film optique antiréfléchissant ou réfléchissant multicouche selon la revendication 1, 2 ou 3.

5. Procédé de formation d'un film antiréfléchissant, comprenant :
la formation d'une couche (26) d'indice élevé de réfraction d'un quart de la longueur d'onde composée d'oxynitrure de titane, d'oxynitrure d'aluminium ou d'oxynitrure de silicium par un procédé de dépôt assisté par des ions, et
la formation d'une couche (27) de faible indice de réfraction d'un quart de la longueur d'onde placée à côté de la couche d'indice élevé de réfraction d'un quart de la longueur d'onde.

6. Procédé selon la revendication 5, dans lequel le procédé de dépôt assisté par des ions comprend la vaporisation d'une matière première de la couche (26) d'indice de réfraction élevé par projection d'électrons d'un canon à électrons (4) sur la matière première, et, simultanément, l'ionisation d'un élément gazeux dans un canon ionique (6) et l'ionisation d'un élément gazeux différent à l'extérieur du canon ionique, et la liaison des éléments gazeux ionisés avec la matière première vaporisée.

7. Procédé selon la revendication 6, dans lequel l'élément gazeux ionisé dans le canon ionique (6) est l'oxygène et l'élément gazeux ionisé à l'extérieur du canon ionique est l'azote.

8. Procédé de formation d'un film réfléchissant, comprenant :
la formation d'une couche (30, 48) de faible indice de réfraction d'un quart de la longueur d'onde, et
la formation, par un procédé de dépôt assisté par des ions, d'une couche (29, 47) d'indice de réfraction élevé d'un quart de la longueur d'onde, composée d'oxynitrure de titane, d'oxynitrure d'aluminium ou d'oxynitrure de silicium, placée à côté de la couche de faible indice de réfraction.

9. Procédé selon la revendication 8, dans lequel le procédé de dépôt assisté par des ions comprend la vaporisation d'une matière première d'une couche d'indice élevé de réfraction (29, 47) par projection d'électrons d'un canon à électrons (4) sur un bloc de la matière première, et, simultanément, l'ionisation d'un élément gazeux par un canon ionique (6) et la liaison de l'élément gazeux ionisé avec la matière première vaporisée.

10. Procédé selon la revendication 9, dans lequel l'élément gazeux est l'azote.

11. Procédé selon la revendication 6, 7, 9 ou 10, dans lequel l'indice de réfraction de la couche d'indice de réfraction élevé (26 ; 29 ; 47) est ajusté par changement de la vitesse de dépôt de la couche d'indice élevé de réfraction (26 ; 29 ; 47).

12. Procédé selon la revendication 11 lorsqu'elle dépend de la revendication 6 ou de la revendication 9, dans lequel la vitesse de dépôt de la couche d'indice de réfraction élevé (26 ; 29 ; 47) est modifiée par changement du courant électrique transmis au canon à électrons (4) qui irradie la matière première.
